(19) Europäisches Patentamt / European Patent Office / Office européen des brevets

(11) **EP 3 054 547 B1**

(12) **FASCICULE DE BREVET EUROPEEN**

(45) Date de publication et mention de la délivrance du brevet:
**01.04.2020 Bulletin 2020/14**

(21) Numéro de dépôt: **16153898.8**

(22) Date de dépôt: **02.02.2016**

(51) Int Cl.:
*H02H 3/027* (2006.01)     *H02H 5/00* (2006.01)
*H02H 5/04* (2006.01)     *H02H 7/00* (2006.01)
*H02H 7/20* (2006.01)     *G01R 21/133* (2006.01)
*G01D 4/00* (2006.01)

(54) **PROCÉDÉ D'ACTIONNEMENT D'UN ORGANE DE COUPURE DANS UN COMPTEUR ÉLECTRIQUE**

VERFAHREN ZUR BETÄTIGUNG EINES ABSCHALTELEMENTS IN EINEM ELEKTRISCHEN ZÄHLER

METHOD FOR ACTUATING A CUT-OFF MEMBER IN AN ELECTRIC METER

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **06.02.2015 FR 1550951**

(43) Date de publication de la demande:
**10.08.2016 Bulletin 2016/32**

(73) Titulaire: **SAGEMCOM ENERGY & TELECOM SAS 92500 Rueil-Malmaison (FR)**

(72) Inventeur: **TEBOULLE, Henri 92500 Rueil Malmaison (FR)**

(74) Mandataire: **Cabinet Le Guen Maillet 3, impasse de la Vigie CS 71840 35418 Saint-Malo Cedex (FR)**

(56) Documents cités:
**EP-A1- 2 080 177     GB-A- 2 461 348
JP-A- 2010 193 679     US-A- 5 489 889
US-A1- 2006 271 314**

**Description**

La présente invention concerne un procédé d'actionnement d'un organe de coupure compris dans un compteur électrique supervisant une installation électrique recevant une alimentation électrique d'un réseau électrique et des dispositifs aptes à mettre en œuvre le procédé.

Un bâtiment, qu'il soit à usage professionnel ou d'habitation, peut être affecté par des évènements dangereux divers tels qu'un tremblement de terre, un incendie, une explosion due au gaz, etc. Des normes de construction et d'équipement de bâtiment évoluent pour prendre en compte ce type d'évènements dangereux. Ces normes visent essentiellement à préserver au maximum chaque occupant d'un bâtiment. Ces normes comprennent des normes de construction antisismiques adaptées à des zones présentant un risque sismique, des normes de résistance aux incendies, des normes d'évacuation, etc. C'est ainsi, par exemple, qu'une législation française récente impose d'équiper chaque bâtiment de moyens de détection d'incendie.

Chaque bâtiment possède généralement au moins une installation électrique connectée à un réseau de fourniture d'électricité. Un compteur électrique, situé en amont de chaque installation électrique, permet de calculer et fournir une information d'énergie active consommée par ladite installation électrique supervisée par ledit compteur électrique. Une tendance actuelle est de remplacer des compteurs électriques dits classiques, nécessitant notamment une intervention humaine pour relever les informations d'énergie active consommée, par des compteurs électriques dits communicants. Un compteur électrique communicant peut être interrogé, contrôlé et manipulé à distance par un opérateur de fourniture d'électricité à partir d'un système d'information centralisé. C'est ainsi, par exemple, que les informations de puissance électrique consommée peuvent être obtenues à distance sans nécessiter un déplacement d'un être humain.

Les compteurs électriques, qu'ils soient communicants ou non, comprennent un organe de coupure. Chaque organe de coupure peut prendre une position ouverte coupant l'alimentation électrique de l'installation électrique que supervise ledit compteur électrique, ou une position fermée permettant l'alimentation électrique de ladite installation électrique. Là encore, dans le cas des compteurs électriques communicants, l'actionnement de l'organe de coupure ne nécessite pas un déplacement d'un être humain. L'organe de coupure peut en effet, dans ce cas, être actionné à distance depuis le système d'information centralisé. Une telle fonctionnalité est utilisée, par exemple, pour couper l'alimentation électrique d'une installation électrique en cas de clôture d'un abonnement de fourniture d'électricité.

Il est connu toutefois que l'électricité peut être un élément aggravant lors d'un tremblement de terre, un incendie ou une fuite de gaz. Par exemple, une étincelle électrique peut provoquer un incendie en cas de fuite de gaz due à un tremblement de terre. Il est donc souhaitable de couper l'alimentation électrique d'une installation électrique en cas d'évènement dangereux.

Couper l'alimentation électrique d'une installation électrique pose des questions d'ordre pratique. Il faut déterminer qui décide que l'alimentation électrique doit être coupée, qui coupe ladite alimentation électrique et définir des critères devant entraîner la coupure de l'alimentation électrique. Un être humain, en prenant en compte des observations de conditions environnementales du bâtiment régnant dans un bâtiment peut décider de lui-même de couper une alimentation électrique en intervenant physiquement, par exemple, sur un disjoncteur électrique. Les conditions environnementales du bâtiment peuvent, par exemple, être de la fumée, une odeur de gaz, des flammes, des secousses sismiques, etc. Mais, certains évènements dangereux peuvent rendre la coupure physique de l'alimentation électrique risquée, voire impossible. C'est ainsi que des consignes de sécurité classiques en cas de séisme préconisent de rester caché sous un meuble pendant la durée du séisme plutôt que de bouger dans un bâtiment. Si on tient compte de ces consignes, se déplacer dans un bâtiment pour couper une alimentation électrique devient impossible. De plus, en cas d'incendie, il n'est pas rare que des fumées ou des flammes empêchent d'accéder au disjoncteur.

Une coupure de courant sans intervention humaine peut donc être préférable dans certains cas. Le brevet EP 2080177 B1 décrit un système de protection contre le feu des installations électriques. Dans ce système, une unité de contrôle reçoit des signaux de la part d'une pluralité de capteurs aptes à détecter des gaz, de la chaleur et de la fumée. L'unité de contrôle est connectée à au moins un organe de coupure apte couper une alimentation électrique d'une installation électrique. Lorsqu'un niveau de gaz, de chaleur ou de fumée détecté par un dit capteur dépasse un seuil, l'unité de contrôle actionne l'organe de coupure pour couper l'alimentation électrique de l'installation électrique. Le système décrit dans le brevet EP 2080177 B1 peut donc, de manière autonome, couper une alimentation électrique d'une installation électrique. Toutefois, ce système ne prend pas en compte une éventuelle présence d'êtres humains dans un bâtiment comprenant l'installation électrique. Or, couper une alimentation électrique dès qu'un évènement dangereux est détecté n'est pas toujours judicieux.

En effet, un évènement dangereux, tel qu'un incendie ou une fuite de gaz, peut être très temporaire et maîtrisé rapidement. Or couper rapidement une alimentation électrique peut avoir des conséquences importantes, comme par exemple un endommagement d'équipements électroniques. Dans le cas d'un évènement dangereux temporaire rapidement maîtrisé, il n'est alors pas nécessaire de couper l'alimentation électrique.

Si l'évènement dangereux n'est pas temporaire et nécessite une évacuation rapide des occupants du bâtiment, couper l'alimentation électrique immédiatement peut rendre difficile l'évacuation. En effet, une coupure d'alimentation électrique pourrait plonger dans un noir total certaines parties du bâtiment essentielles à l'évacuation (escaliers, couloirs), et rendre inutilisables des ascenseurs ou des escalators.

Par ailleurs, réalimenter électriquement une installation électrique suite à une coupure due à un évènement dangereux est un problème non négligeable. Une installation électrique peut avoir été endommagée de telle sorte qu'elle se trouve en court-circuit. Une réalimentation électrique intempestive d'une installation électrique endommagée risquerait alors de causer de nouveaux dégâts.

Il est souhaitable de pallier ces différents inconvénients de l'état de la technique.

Il est notamment souhaitable de fournir une solution qui permette d'une part, de s'assurer qu'un évènement dangereux dans un bâtiment nécessite réellement une coupure d'alimentation électrique et d'autre part, de préserver au mieux chaque occupant du bâtiment en lui laissant un temps suffisant pour évacuer le bâtiment. Il est de plus souhaitable de prévoir une solution de réalimentation d'une installation électrique ayant subi une coupure due à un évènement dangereux offrant des garanties raisonnables de sécurité.

Il est notamment souhaitable de fournir une solution qui soit simple à mettre en œuvre et à faible coût.

Selon un premier aspect, la présente invention concerne un procédé d'actionnement d'un organe de coupure compris dans un compteur électrique supervisant une installation électrique d'un bâtiment, l'installation électrique recevant une alimentation électrique d'un réseau électrique via ledit compteur électrique, l'organe de coupure pouvant prendre une position ouverte coupant l'alimentation électrique de ladite installation électrique ou une position fermée permettant l'alimentation électrique de ladite installation électrique. Le procédé comprend les étapes suivantes mises en œuvre par le compteur électrique : obtenir pour chaque signal fourni par un système, dit système capteur, un critère d'actionnement de l'organe de coupure adapté audit signal et comprenant une valeur de détection et une valeur de temporisation, chaque signal étant représentatif de conditions environnementales du bâtiment régnant dans un voisinage dudit système capteur ; pour chaque signal fourni par le système capteur, rechercher une singularité dans ledit signal, une singularité étant détectée dans ledit signal lorsqu'au moins une valeur dudit signal atteint la valeur de détection correspondant audit signal ; lorsqu'une singularité est détectée dans un signal fourni par le système capteur, démarrer une mesure d'une durée de ladite singularité ; décider (305), lorsque la durée de ladite singularité atteint (304) la valeur de temporisation correspondant audit signal, d'un instant auquel l'organe de coupure (172) doit être actionné dans la position ouverte ; et, actionner l'organe de coupure (172) dans la position ouverte à l'instant décidé.

En évitant de couper l'alimentation électrique d'une installation électrique dès qu'une singularité est trouvée dans un signal fourni par le système capteur, le procédé permet d'éviter des coupures injustifiées de l'alimentation électrique qui pourraient endommager des équipements électroniques. Ainsi, si un incendie a été rapidement maîtrisé, celui-ci ne déclenche pas de coupure d'alimentation électrique. Si un tremblement de terre est très bref, celui-ci ne déclenche pas de coupure d'alimentation électrique.

Selon un mode de réalisation, le compteur électrique comprend un moyen d'alimentation électrique interne, le moyen d'alimentation électrique interne alimentant le compteur électrique lorsque l'alimentation électrique par le réseau électrique est coupée, pour permettre l'actionnement de l'organe de coupure.

Il est connu qu'un évènement dangereux peut endommager un réseau électrique, ce qui peut couper l'alimentation électrique d'une installation électrique. En utilisant une alimentation électrique interne, on s'assure que le procédé peut être mis en œuvre, même si l'installation électrique n'est pas alimentée. L'installation électrique est alors protégée en cas de réalimentation électrique par le réseau électrique, ce qui peut permettre par exemple d'éviter des courts circuits dans l'installation électrique.

Selon un mode de réalisation, chaque critère d'actionnement comprend un délai d'actionnement et une information représentative d'un instant de démarrage du délai d'actionnement, et lorsque le compteur électrique décide d'actionner l'organe de coupure dans la position ouverte, l'organe de coupure est actionné dans la position ouverte à un instant dépendant du délai d'actionnement et de l'information représentative de l'instant de démarrage du délai d'actionnement correspondant au signal dans lequel a été détectée la singularité.

De cette manière, l'alimentation électrique de l'installation électrique n'est pas coupée dès que la durée d'une singularité détectée dans un signal atteint la valeur de temporisation correspondant audit signal, ce qui laisse le temps à des occupants d'évacuer un bâtiment dans lequel se produit un évènement dangereux.

Selon un mode de réalisation, le système capteur comprend au moins un capteur apte à fournir un signal représentatif de mouvements sismiques, dit capteur sismique, et/ou au moins un capteur de température et/ou un capteur de fumée et/ou au moins un capteur de gaz inflammables.

Plusieurs types d'évènements dangereux sont donc considérés dans le procédé.

Selon un mode de réalisation, lorsqu'un signal dans lequel a été détectée une singularité est fourni par un dit capteur sismique, l'organe de coupure est actionné dans la position ouverte après un délai égal au délai d'actionnement adapté au signal fourni par le capteur sismique à compter de la fin de la singularité.

Il est connu qu'un bâtiment ne doit pas être évacué pendant un tremblement de terre, mais après la fin du tremblement de terre. Le procédé permet donc d'adapter la coupure d'alimentation électrique au type de l'évènement.

Selon un mode de réalisation, lorsqu'un signal dans lequel a été détectée une singularité est fourni par un dit capteur de température ou par un dit capteur de fumée, l'organe de coupure est actionné dans la position ouverte après un délai égal au délai d'actionnement adapté au signal fourni respectivement par le capteur de température ou par le capteur de fumée à compter du début de la détection de la singularité.

Selon un mode de réalisation, lorsqu'un signal dans lequel a été détectée une singularité est fourni par un dit capteur de gaz inflammables, le délai d'actionnement est nul et l'organe de coupure est actionné dès que la durée de la singularité atteint la valeur de temporisation.

Selon un mode de réalisation, le système capteur comprend en outre un détecteur fournissant un signal représentatif de présence ou d'absence d'êtres vivants dans le bâtiment, et l'instant auquel l'organe de coupure (172) doit être actionné est déterminé en prenant en compte ledit signal représentatif de présence ou d'absence d'êtres vivants.

Selon un mode de réalisation, le compteur électrique reçoit chaque critère d'actionnement de l'organe de coupure en provenance d'un système d'information connecté au compteur électrique par un réseau de communication établi par courants porteurs en ligne sur ledit réseau électrique (2).

Selon un mode de réalisation, le compteur électrique transmet, via ledit réseau de communication, un signal d'alarme en direction du système d'information dès que la durée de la singularité détectée atteint la valeur de temporisation et tant que la singularité ne cesse pas.

Selon un mode de réalisation, suite à l'actionnement de l'organe de coupure dans la position ouverte après détection dans un signal d'une singularité d'une durée au moins égale à la valeur de temporisation correspondant audit signal, le compteur électrique actionne l'organe de coupure dans la position fermée après réception d'une commande de la part du système d'information via ledit réseau de communication.

Selon un deuxième aspect, la présente invention concerne un dispositif de type compteur électrique supervisant une installation électrique d'un bâtiment, l'installation électrique recevant une alimentation électrique d'un réseau électrique via ledit compteur électrique, et comprenant un organe de coupure pouvant prendre une position ouverte coupant l'alimentation électrique de ladite installation électrique ou une position fermée permettant l'alimentation électrique de ladite installation électrique. Le dispositif comprend les moyens suivants : des moyens d'obtention pour obtenir, pour chaque signal fourni au dispositif par un système, dit système capteur, un critère d'actionnement de l'organe de coupure adapté audit signal et comprenant une valeur de détection et une valeur de temporisation, chaque signal étant représentatif de conditions environnementales du bâtiment régnant dans un voisinage dudit système capteur ; des moyens de recherche mis en œuvre sur chaque signal fourni par le système capteur, pour rechercher une singularité dans chaque signal, une singularité étant détectée dans un dit signal lorsqu'au moins une valeur dudit signal atteint la valeur de détection correspondant audit signal ; des moyens de mesure pour mesurer une durée d'une singularité lorsqu'une singularité est détectée dans un dit signal fourni par le système capteur ; des moyens de décision pour décider, lorsque la durée de ladite singularité atteint la valeur de temporisation correspondant audit signal, d'un instant auquel l'organe de coupure doit être actionné dans la position ouverte ; des moyens d'actionnement pour actionner l'organe de coupure dans la position ouverte à l'instant décidé ; des moyens d'alimentation électrique interne, aptes à alimenter le compteur électrique lorsque l'alimentation électrique par le réseau électrique est coupée, pour permettre l'actionnement de l'organe de coupure.

Selon un troisième aspect, la présente invention concerne un dispositif de type système d'information connecté à au moins un compteur électrique par l'intermédiaire d'un réseau de communication, chaque compteur électrique supervisant une installation électrique d'un bâtiment et recevant une alimentation électrique d'un réseau électrique, le compteur électrique comprenant un organe de coupure pouvant prendre une position ouverte coupant l'alimentation électrique de ladite installation électrique ou une position fermée permettant l'alimentation électrique de ladite installation électrique. Le dispositif comprend les moyens suivants : des moyens d'obtention pour obtenir, pour chaque compteur électrique, un critère d'actionnement de l'organe de coupure pour chaque signal fourni par un système, dit système capteur, fournissant au compteur électrique au moins un signal représentatif de conditions environnementales du bâtiment régnant dans un voisinage dudit système capteur, chaque critère de coupure étant adapté au signal auquel il correspond et comprenant une valeur de détection et une valeur de temporisation ; des moyens de fourniture pour fournir à chaque compteur électrique, via le réseau de communication, chaque critère de coupure déterminé pour ledit compteur électrique ; des moyens de réception pour recevoir, via le réseau de communication, un signal d'alarme transmis par un compteur électrique, suite à une détection dans un signal fourni par le système capteur dudit compteur électrique d'une singularité d'une durée au moins égale à la valeur de la temporisation correspondant audit signal, une singularité étant détectée dans ledit signal lorsqu'au moins une valeur dudit signal atteint la valeur de détection correspondant audit signal ; des moyens de commande pour autoriser un compteur électrique, ayant actionné en position ouverte son organe de coupure suite à une détection d'une singularité dans un dit signal fourni par le système capteur d'une durée égale à la valeur de temporisation correspondant audit signal, à actionner en position fermée son organe de coupure lorsque le dispositif ne reçoit plus de signal d'alarme de la part dudit compteur électrique.

Selon un quatrième aspect, la présente invention concerne un programme d'ordinateur, comprenant des instructions pour mettre en œuvre, par un compteur électrique, le procédé selon le premier aspect, lorsque ledit programme est exécuté par un processeur dudit compteur électrique.

Selon un cinquième aspect, la présente invention concerne des moyens de stockage, stockant un programme d'ordinateur comprenant des instructions pour mettre en œuvre, par un compteur électrique, le procédé selon le premier aspect, lorsque ledit programme est exécuté par un processeur dudit compteur électrique.

Les caractéristiques de l'invention mentionnées ci-dessus, ainsi que d'autres, apparaîtront plus clairement à la lecture de la description suivante d'un exemple de réalisation, ladite description étant faite en relation avec les dessins joints, parmi lesquels :

- la Fig. 1 illustre schématiquement un contexte dans lequel l'invention peut être mise en œuvre ;
- la Fig. 2 illustre schématiquement un exemple d'architecture matérielle d'un module de traitement d'un compteur électrique mettant en œuvre l'invention ;
- la Fig. 3 illustre schématiquement un procédé d'actionnement d'un organe de coupure compris dans un compteur électrique ;
- la Fig. 4A illustre schématiquement un procédé de recherche d'une singularité dans chaque signal fourni par un système, dit système capteur, chaque dit signal étant représentatif de conditions environnementales régnant dans un voisinage dudit système capteur ;
- la Fig. 4B illustre schématiquement un exemple d'une procédure permettant de lancer une mesure d'une durée de singularité;
- la Fig. 4C illustre schématiquement un exemple de procédure permettant de comparer une durée d'une singularité en cours de mesure à une valeur de temporisation ; et,
- la Fig. 4D illustre schématiquement un exemple d'une procédure de détermination d'un instant d'actionnement d'un organe de coupure compris dans un compteur électrique.

L'invention est décrite par la suite dans un contexte dans lequel des évènements dangereux comprenant des séismes, des incendies, des fuites de gaz inflammables sont pris en compte pour déterminer si une coupure d'alimentation électrique doit être mise en œuvre. Des capteurs adaptés à des détections de séismes, d'incendies ou de fuites de gaz sont alors utilisés. L'invention est toutefois adaptée à d'autres évènements dangereux nécessitant des coupures d'alimentation électrique tels que des vents violents, des inondations, etc. Des capteurs adaptés à ces différents évènements dangereux seraient alors utilisés.

De plus, nous décrivons par la suite une mise en œuvre de l'invention dans un bâtiment comprenant une installation électrique. Les capteurs utilisés pour détecter des évènements dangereux sont intégrés à l'intérieur du bâtiment. L'invention est toutefois adaptée à des capteurs qui seraient extérieurs au bâtiment, y compris des capteurs extérieurs qui seraient communs à plusieurs bâtiments, comme un capteur de séismes de type sismographe.

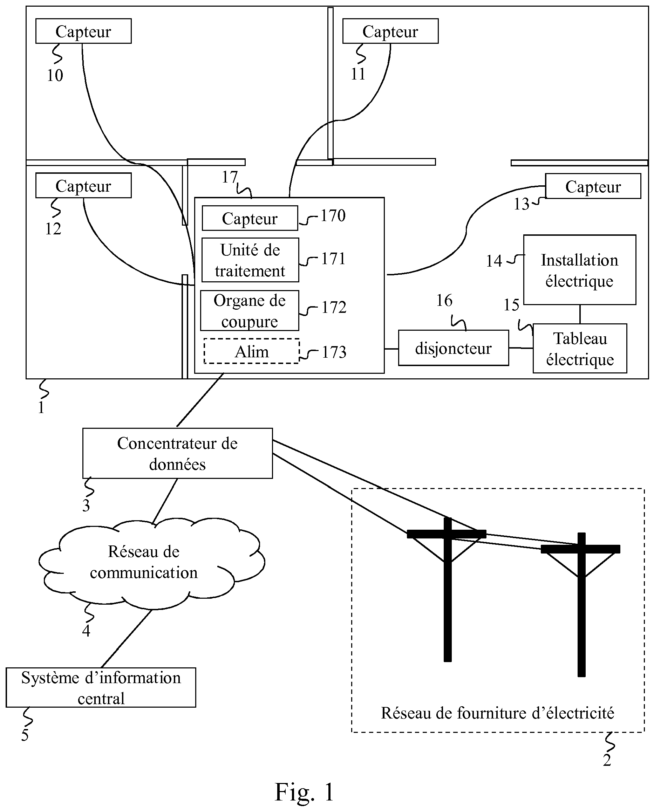

La **Fig. 1** illustre schématiquement un contexte dans lequel l'invention peut être mise en œuvre.

Dans le contexte de la Fig. 1, un réseau de fourniture d'électricité 2 assure une alimentation électrique d'une installation électrique 14 d'un bâtiment 1. En amont de l'installation électrique 14 se trouve un tableau électrique 15 répartissant l'alimentation électrique sur différentes parties de l'installation électrique 14, un disjoncteur 16 permettant de couper de manière centralisée l'alimentation électrique de l'installation électrique 14 et un compteur électrique 17 permettant, entre autres, de calculer et fournir une information d'énergie active consommée par l'installation électrique 14. Sur une ligne électrique reliant le réseau de fourniture électrique 2 au compteur électrique 17 se trouve un concentrateur de données (« data concentrator » en terminologie anglo-saxonne) 3.

Un concentrateur de données permet de connecter une pluralité de réseau bas débit avec un réseau haut débit, en utilisant un minimum de connexion sur le réseau haut débit. Dans le contexte décrit en relation avec la Fig. 1, le concentrateur de données 2 permet de connecter une pluralité de réseaux de communications par courants porteurs (*i.e.* Courant Porteur en Ligne (CPL), « PowerLine Communications (PLC) » en terminologie anglo-saxonne) avec un réseau 4 tel que le réseau Internet. L'un des réseaux de communication par courant porteur connecte le compteur électrique 17 avec le concentrateur de données 3. Par le truchement du réseau de communication par courant porteur connectant le compteur électrique 17 avec le concentrateur de données 3 et le réseau 4, des communications sont possibles entre le compteur électrique 17 et un système d'information centralisé 5.

Les communications entre le compteur électrique 17 et le système d'information centralisé 5 utilisent un protocole de communication par courant porteur bas niveau (i.e. niveau physique) tel que le protocole défini par le standard G3-PLC (CPL de troisième génération: « Third Generation PLC » en terminologie anglo-saxonne. ITU-T G.9903, Emetteurs/récepteurs CPL utilisant un multiplexage par division de fréquences de bande étroite orthogonales pour CPL de troisième génération, « Narrowband orthogonal frequency division multiplexing power line communication transceivers for G3-PLC networks » en terminologie anglo-saxonne) entre le compteur électrique 17 et le concentrateur de données 3 et un protocole de réseau à commutation de paquets tel que le protocole Ethernet (IEEE 802.3) entre le concentrateur de données 3 et le système d'information centralisé 5.

Des échanges de données entre le compteur électrique 17 et le système d'information centralisé 5 sont assurés, par exemple, en utilisant des outils spécifiés dans la spécification DLMS/COSEM (spécification de messages pour langage de dispositifs, « Device Language Message Spécification » en terminologie anglo-saxonne / Spécification d'accompagnement pour mesure d'énergie, « COmpanion Specification for Energy Metering » en terminologie anglo-saxonne). La spécification DLMS/COSEM, intégrée dans l'ensemble de standards IEC 62056, spécifie un modèle de données et des protocoles de communication destinés à des échanges de données entre des équipements de métrage.

Par exemple, les informations d'énergie active consommée par l'installation électrique 14 sont véhiculées en utilisant des messages spécifiés par la spécification DLMS/COSEM. Ces messages sont appelés par la suite messages DLMS/COSEM.

Par ailleurs, le compteur électrique 17 est connecté avec des capteurs 10, 11, 12 et 13 avec qui il communique. De plus, le compteur électrique 17 comprend un capteur 170 intégré dans le compteur électrique. Les capteurs 10, 11, 12, 13 et 170 forment un système dit système capteur. Chaque capteur du système capteur fournit au compteur électrique 17 un signal représentatif de conditions environnementales du bâtiment 1 régnant au voisinage du système capteur. Dans un mode de réalisation, le système capteur comprend au moins un capteur sismique tel qu'un accéléromètre apte à détecter des secousses et des vibrations anormales, par exemple provoquées par un tremblement de terre, au moins un capteur de fumée, au moins un capteur de température et au moins un capteur de gaz inflammables.

Dans un mode de réalisation, chaque capteur du système capteur fournit en continu au compteur électrique 17 un signal représentatif de conditions environnementales du bâtiment 1 régnant au voisinage du système capteur.

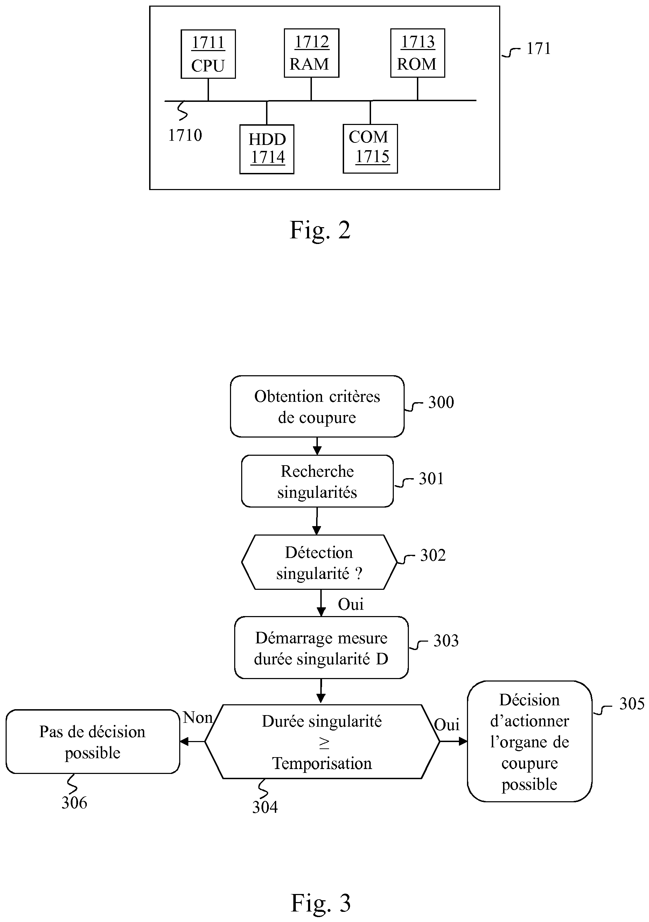

Le compteur électrique 17 comprend, en outre, un module de traitement 171 que nous décrivons par la suite en relation avec la Fig. 2 et un organe de coupure 172. L'organe de coupure 172 peut prendre une position ouverte coupant l'alimentation électrique de l'installation électrique 14 ou une position fermée permettant l'alimentation électrique de l'installation électrique 14.

Dans un mode de réalisation, le compteur électrique 17 comprend un moyen d'alimentation électrique interne 173, tel qu'une batterie, permettant d'assurer le fonctionnement du compteur électrique 17 en cas de coupure de l'alimentation électrique de l'installation électrique 14 en amont du compteur électrique et notamment une mise en œuvre d'un procédé selon l'invention décrit par la suite en relation avec la Fig. 3.

Dans un mode de réalisation, le système capteur comprend, en outre, un détecteur de présence d'être vivant apte à détecter si au moins un être vivant est présent dans le bâtiment 1.

La Fig. 2 illustre schématiquement une architecture matérielle du module de traitement 171 compris dans le compteur électrique 17.

Selon l'exemple d'architecture matérielle représenté à la Fig. 2, le module de traitement 171 comprend alors, reliés par un bus de communication 1710: un processeur ou CPU (« Central Processing Unit» en anglais) 1711 ; une mémoire vive RAM (« Random Access Memory » en anglais) 1712; une mémoire morte ROM (« Read Only Memory » en anglais) 1713 ; une unité de stockage telle qu'un disque dur ou un lecteur de support de stockage, tel qu'un lecteur de cartes SD (« Secure Digital » en anglais) 1714 ; au moins une interface de communication 1715 permettant au module de traitement 171 de communiquer avec chaque capteur du système capteur mais aussi permettant au compteur électrique 17 de communiquer avec le système d'information centralisé 5.

Le processeur 1711 est capable d'exécuter des instructions chargées dans la RAM 1712 à partir de la ROM 1713, d'une mémoire externe (non représentée), d'un support de stockage (tel qu'une carte SD), ou d'un réseau de communication. Lorsque le module de traitement 171 est mis sous tension, le processeur 1711 est capable de lire de la RAM 1712 des instructions et de les exécuter. Ces instructions forment un programme d'ordinateur causant la mise en œuvre, par le processeur 1711, de tout ou partie des algorithmes et étapes décrits ci-après en relation avec la Fig. 3.

Tout ou partie des algorithmes et étapes décrits ci-après en relation avec la Fig. 3 peut être implémenté sous forme logicielle par exécution d'un ensemble d'instructions par une machine programmable, par exemple un DSP (« Digital Signal Processor » en anglais) ou un microcontrôleur, ou être implémenté sous forme matérielle par une machine ou un composant dédié, par exemple un FPGA (« Field-Programmable Gate Array » en anglais) ou un ASIC (« Application-Specific Integrated Circuit » en anglais).

La Fig. 3 illustre schématiquement un procédé d'actionnement de l'organe de coupure 172 compris dans le compteur électrique 17.

Dans une étape 300, le module de traitement 171 du compteur électrique 17 obtient, pour chaque signal fourni par le système capteur, un critère d'actionnement de l'organe de coupure 172 adapté audit signal. Dans un mode de réalisation, le critère d'actionnement comprend une valeur de détection et une valeur de temporisation. Chaque critère d'actionnement est obtenu de l'unité de stockage 1714 ou de la RAM 1712.

Les critères d'actionnement sont stockés, par exemple, sous forme de tableau.

Le tableau 1 (ci-après) donne un exemple de tableau permettant de stocker des critères d'actionnement. Dans une colonne « type de critère », le tableau 1 stocke des critères utilisables pour déterminer si un actionnement de l'organe de coupure 172 est nécessaire. Une colonne « actif » indique si un critère doit être pris en compte pour déterminer si un actionnement de l'organe de coupure 172 est nécessaire. Une colonne « valeur de détection » associe une valeur de détection à un critère. Une colonne « valeur de temporisation » associe une valeur de temporisation à un critère. Une colonne « action » associe une action à un critère, ladite action devant être mise en œuvre lorsque le critère de coupure est vérifié.

Tableau 1

| N° de ligne | Type de critère | Actif | Valeur de détection | Valeur de temporisation | Action |
|---|---|---|---|---|---|
| 1 | Accélération selon un axe x | Non | 0 | 300s | Ouverture |
| 2 | Accélération selon un axe y | Non | 0 | 300s | Ouverture |
| 3 | Accélération selon un axe z | Oui | $17 \text{ mm/s}^2$ | 300s | Ouverture |
| 4 | Norme de l'accélération | Oui | $17 \text{ mm/s}^2$ | 300s | Ouverture |
| 5 | Fumée | Oui | 5 | 500s | Ouverture |
| 6 | Température | Oui | 27.4°c | 500s | Ouverture |
| 7 | Gaz | Oui | 1 | 60s | Ouverture |

On note que dans un mode de réalisation, les colonnes « actif » et « action » sont absentes du tableau 1. Une absence des colonnes «actif» et «action» indique respectivement que le critère correspondant doit être pris en compte pour déterminer si un actionnement de l'organe de coupure 172 est nécessaire et que l'action à mettre en œuvre est systématiquement une ouverture de l'organe de coupure 172.

Dans des lignes « 1 » à « 4 » du tableau 1 sont stockées des informations correspondant à des critères adaptés au signal fourni par l'accéléromètre. Ces critères correspondent à des accélérations selon trois axes, i.e. un axe horizontal « x » parallèle à un mur supportant le compteur électrique 17, un axe horizontal « y » perpendiculaire au mur supportant le compteur électrique 17 et un axe vertical « z » perpendiculaire aux axes « x » et « y », et à une norme d'un vecteur d'accélération calculée à partir des accélérations suivant les axes « x », « y » et « z ». Dans l'exemple de tableau décrit en relation avec le tableau 1, les critères d'accélération suivant les axes « x » et « y » sont associés à des informations identiques. En effet, la colonne « actif » indique que ces critères ne doivent pas être pris en compte, la colonne « valeur de détection » indique que la valeur de détection est égale à « $0 \text{ mm/s}^2$ », la colonne « valeur de temporisation » indique que la valeur de temporisation est égale à « 300 s » et la colonne « action » indique que l'action est une ouverture de l'organe de coupure.

Le critère d'accélération suivant l'axe « z » et le critère correspondant à la norme du vecteur d'accélération sont associés à des informations identiques. La colonne « actif » indique que ces critères doivent être pris en compte, la colonne « valeur de détection » indique que la valeur de détection est égale à « $17 \text{ mm/s}^2$ », la colonne « valeur de temporisation » indique que la valeur de temporisation est égale à « 300 s » et la colonne « action » indique que l'action est une ouverture de l'organe de coupure.

Dans une ligne « 5 » sont stockées des informations correspondant à un critère adapté au signal fourni par le capteur de fumée. La colonne « actif » indique que ce critère doit être pris en compte, la colonne « valeur de détection » indique que la valeur de détection est égale à « 5 ». Dans un mode de réalisation, le capteur de fumée fournit des valeurs allant de « 0 » à « 10 » et correspondant à des mesures d'opacité. Une valeur de détection égale à « 5 » correspond donc à une mesure d'opacité moyenne. La colonne « valeur de temporisation » indique que la valeur de temporisation est égale à « 500 s » et la colonne « action » indique que l'action est une ouverture de l'organe de coupure.

Dans une ligne « 6 » sont stockées des informations correspondant à un critère adapté au signal fourni par le capteur de température. La colonne « actif » indique que ce critère doit être pris en compte, la colonne « valeur de détection » indique que la valeur de détection est égale à « 27,4°c », la colonne « valeur de temporisation » indique que la valeur de temporisation est égale à « 500 s » et la colonne « action » indique que l'action est une ouverture de l'organe de coupure.

Dans une ligne « 7 » sont stockées des informations correspondant à un critère adapté au signal fourni par le capteur de gaz inflammables. La colonne « actif » indique que ce critère doit être pris en compte, la colonne « valeur de détection » indique que la valeur de détection est égale à « 1 ». Le capteur de gaz inflammables fournit un signal prenant des valeurs booléennes, une valeur « 0 » indiquant qu'aucun gaz inflammable n'est détecté et une valeur « 1 » indiquant qu'un gaz inflammable est détecté. La colonne « valeur de temporisation » indique que la valeur de temporisation est égale à « 60 s » et la colonne « action » indique que l'action est une ouverture de l'organe de coupure.

Chaque critère d'actionnement de l'organe de coupure 172 a été préalablement transmis par le système d'information centralisé 5 dans des messages DLMS/COSEM.

Dans un mode de réalisation, le système d'information centralisé 5 stocke dans une base de données des critères d'actionnement d'organes de coupure pour un ensemble de compteurs électriques auquel il est relié. Chaque critère d'actionnement de l'organe de coupure a été déterminé, par exemple par un opérateur de fourniture d'énergie gérant le réseau électrique 2, en se basant sur des retours d'expérience. Ces retours d'expérience peuvent par exemple être des temps moyens d'évacuation d'un bâtiment en cas d'incendie, de fuite de gaz ou de tremblement de terre. Ces temps moyens d'évacuation peuvent par exemple, dépendre d'une hauteur ou d'une surface du bâtiment. Ainsi, l'opérateur définit, en utilisant ce type de retour d'expérience, des valeurs de temporisation qui permettent de préserver au mieux les occupants d'un bâtiment. Par exemple, une valeur de temporisation en cas de tremblement de terre n'est pas la même qu'une valeur de temporisation en cas de fuite de gaz inflammables. En cas de tremblement de terre, la valeur de temporisation doit permettre une évacuation aussi rapide que possible du bâtiment. Il est alors préférable d'alimenter en électricité le bâtiment pendant l'évacuation pour laisser de la lumière et alimenter des ascenseurs ou des escalators. L'électricité n'est alors coupée que lorsque les occupants ont pu évacuer le bâtiment. La valeur de temporisation peut alors être déterminée en fonction d'un temps moyen d'évacuation d'un bâtiment. En cas de fuite de gaz inflammables, il est préférable de couper rapidement l'alimentation en courant du bâtiment pour éviter qu'une étincelle électrique n'enflamme le gaz inflammable. Dans ce cas, la valeur de temporisation peut correspondre à un temps nécessaire pour vérifier que la fuite de gaz n'est pas temporaire, mais ne pas prendre en compte un temps d'évacuation du bâtiment.

Les retours d'expérience peuvent aussi être des valeurs de détection ayant nécessité une coupure d'une alimentation en électricité. Par exemple, les retours d'expérience peuvent montrer qu'une température supérieure à une température seuil est généralement synonyme d'un incendie pour lequel il était préférable de couper l'alimentation en électricité.

Les critères d'actionnement peuvent être globaux et ne pas prendre en compte des spécificités d'un bâtiment, ou dédiés à un bâtiment, par exemple, en prenant en compte la taille, la surface ou une localisation géographique du bâtiment.

Dans une étape 301, pour chaque signal fourni par le système capteur, le module de traitement 171 du compteur électrique 17 recherche une singularité dans ledit signal. Le module de traitement procède donc à plusieurs recherches de singularités en parallèle lorsque le système capteur comprend plusieurs capteurs. Une singularité est détectée dans un signal fourni par le système capteur lorsqu'au moins une valeur dudit signal atteint la valeur de détection correspondant audit signal. On considère ici qu'une valeur d'un signal atteint une valeur de détection lorsqu'elle est supérieure ou égale à la valeur de détection. Chaque singularité recherchée possède donc des caractéristiques dépendantes du signal dans lequel elle est recherchée. Lorsque la colonne « actif » est présente, la recherche de singularité se fait uniquement pour les critères devant être pris en compte pour déterminer si un actionnement de l'organe de coupure 172 est nécessaire.

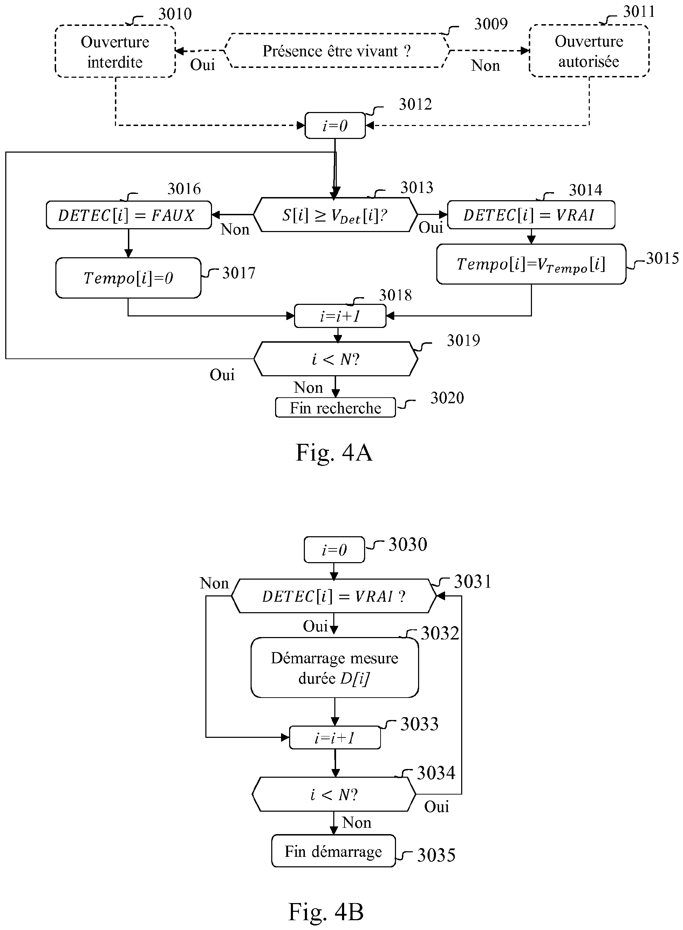

En reprenant l'exemple du tableau 1, des singularités sont détectées dans les signaux fournis par le système capteur dans les cas suivants : une singularité est détectée dans le signal fourni par l'accéléromètre lorsqu'au moins une valeur dudit signal indique qu'une accélération suivant l'axe « z » ou une norme d'un vecteur accélération a atteint ou dépassé la valeur de détection « 17 mm/s$^2$ » ; Une singularité est détectée dans le signal fourni par le capteur de fumée lorsqu'au moins une valeur dudit signal indique qu'une valeur d'opacité supérieure ou égale à la valeur de détection « 5 » a été mesurée ; Une singularité est détectée dans le signal fourni par le capteur de gaz inflammables lorsqu'au moins une valeur dudit signal indique qu'une présence d'un gaz inflammable a été détectée, i.e. au moins une valeur du signal fournie par le capteur de gaz est égale à la valeur booléenne 1. Nous détaillons par la suite, en relation avec la Fig. 4A, un exemple d'une mise en œuvre de l'étape 301.

Lorsque, lors d'une étape 302, une singularité est détectée dans un signal fourni par le système capteur, le module de traitement 171 démarre, lors d'une étape 303, une mesure d'une durée de la singularité détectée. On note que, puisque plusieurs recherches de singularité sont mises en œuvre en parallèle, potentiellement, plusieurs singularités peuvent être détectées au même moment, ou à des instants proches, dans des signaux différents. Par conséquent, le module de traitement 171 du compteur 17 peut mesurer en parallèle la durée de plusieurs singularités différentes. Nous détaillons par la suite, en relation avec la Fig. 4B, un exemple d'une mise en œuvre de l'étape 303.

Pour qu'une détection d'une singularité entraîne une décision d'actionnement de l'organe de coupure 172, il faut que ladite singularité se prolonge d'une durée égale à une valeur de temporisation. Comme décrit en relation avec le tableau 1, chaque critère comprend une valeur de temporisation adaptée au signal fourni par le capteur correspondant audit critère. Dans l'exemple décrit en relation avec le tableau 1, chaque critère adapté au signal fourni par l'accéléromètre comprend une valeur de temporisation égale à « 300 s », le critère adapté au signal fourni par le capteur de fumée comprend une valeur de temporisation de « 500 s », le critère adapté au signal fourni par le capteur de température comprend une valeur de temporisation de « 500 s », le critère adapté au signal fourni par le capteur de gaz inflammables comprend une valeur de temporisation de « 60 s ». On considère ici qu'une singularité détectée dans un signal s'est prolongée sur une durée égale à la valeur de temporisation correspondant audit signal lorsque, sur la durée égale à la valeur de temporisation, un pourcentage de valeur dudit signal, égale ou supérieure à la valeur de détection, est supérieur ou égal à un pourcentage seuil. Dans un mode de réalisation, le pourcentage seuil est en général égal à « 90% ». Toutefois, chaque critère de coupure peut être associé à un pourcentage seuil différent.

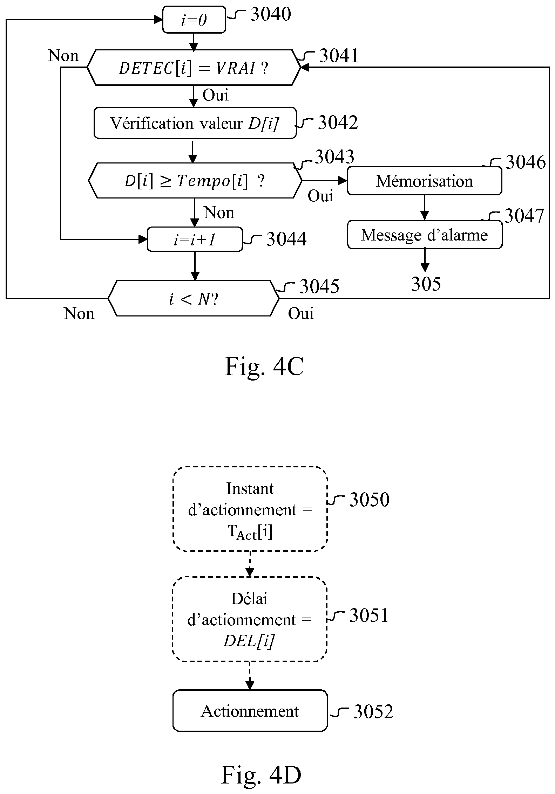

Lors d'une étape 304, le module de traitement 171 du compteur électrique 17 compare régulièrement la durée de chaque singularité détectée à la valeur de temporisation correspondant au signal dans lequel a été détectée ladite singularité. L'étape 304 est détaillée en relation avec la Fig. 4C.

Lorsqu'une singularité détectée dans un signal se prolonge sur une durée égale à la valeur de temporisation correspondant audit signal, l'étape 304 est suivie d'une étape 305. Lors de l'étape 305, le module de traitement 171 du compteur électrique 17 décide d'un instant auquel l'organe de coupure 172 doit être actionné dans la position ouverte. L'étape 305 est détaillée en relation avec la Fig. 4D. L'organe de coupure est actionné dans la position ouverte à l'instant décidé.

Lorsque chaque singularité détectée dans un signal cesse avant que la durée de ladite singularité atteigne la valeur de temporisation correspondant audit signal, le module de traitement 171 du compteur électrique 17 détermine que l'organe de coupure 172 ne doit pas être actionné.

La **Fig. 4A** illustre schématiquement un procédé de recherche d'une singularité dans chaque signal fourni par le système capteur.

Dans une étape 3012, le module de traitement 171 initialise une variable $i$ à « 0 ». Cette variable $i$ est utilisée pour parcourir chaque signal fourni par le système capteur.

Dans une étape 3013, le module de traitement 171 obtient une valeur courante $S[i]$ d'un signal d'indice $i$ fourni par le système capteur. Le signal d'indice $i$ est par exemple le signal fourni par l'accéléromètre. Lors de l'étape 3013, le module de traitement 171 compare la valeur courante $S[i]$ à la valeur de détermination $V_{Det}[i]$ correspondant au signal d'indice $i$. Dans le cas du signal fourni par l'accéléromètre, la valeur courante du signal $S[i]$ à trois composantes $(S_x[i], S_y[i], S_z[i])$ correspondant respectivement aux trois axes $x$, $y$ et $z$. La valeur de détermination $V_{Det}[i]$ adaptée au signal fourni par l'accéléromètre comprend 4 composantes $(V_{Det}^x[i], V_{Det}^y[i], V_{Det}^z[i], V_{Det}^N[i])$, la composante $V_{Det}^x[i]$ correspondant à la valeur de détection pour l'axe x, la composante $V_{Det}^y[i]$ correspondant à la valeur de détection pour l'axe $y$, la composante $V_{Det}^z[i]$ correspondant à la valeur de détection pour l'axe $z$, et la composante $V_{Det}^N[i]$ correspondant à la valeur de détection pour la norme du vecteur d'accélération correspondant aux trois premières composantes. Dans le cas de l'exemple décrit par le tableau 1, seules la composante selon l'axe z et la norme sont à prendre en compte dans la recherche d'une singularité. Ces deux composantes restantes sont traitées séparément lors de l'étape 3013, comme s'il s'agissait de deux signaux différents. Si $S_z[i]$ (respectivement la norme de $S[i]$) est supérieure ou égale à $V_{Det}^z[i]$ (respectivement $V_{Det}^N[i]$), l'étape 3013 est suivie d'une étape 3014. Sinon, l'étape 3013 est suivie d'une étape 3016. On note que la norme de $S[i]$ est égale à $\sqrt{S_x[i]^2 + S_y[i]^2 + S_z[i]^2}$.

Lors de l'étape 3014, une variable booléenne $DETEC[i]$ est positionnée à la valeur «VRAI ». La variable $DETEC[i]$ permet d'indiquer qu'une singularité a été détectée dans le signal d'indice $i$. Dans le cas du signal fourni par l'accéléromètre, la variable $DETEC[i]$ possède quatre composantes $(DETEC_x[i], DETEC_y[i], DETEC_z[i], DETEC_N[i])$ correspondant aux trois axes $x$, $y$, $z$ et à la norme. Dans le cas de l'exemple décrit par le tableau 1, seules la composante selon l'axe z et la norme sont à prendre en compte dans la recherche d'une singularité. Les composantes $DETEC_z[i]$ et $DETEC_N[i]$ sont traitées séparément. Si la composante $S_z[i]$ (respectivement la norme de $S[i]$) est supérieure ou égale à la valeur de détection $V_{Det}^z[i]$ (respectivement $V_{Det}^N[i]$), la variable $DETEC_z[i]$ (respectivement $DETEC_N[i]$) est initialisée à la valeur « VRAI ».

Lors de l'étape 3016, la variable booléenne $DETEC[i]$ est positionnée à la valeur « FAUX ». Dans le cas du signal fourni par l'accéléromètre, si la composante $S_z[i]$ (respectivement la norme de $S[i]$) est inférieure à la valeur de détection $V_{Det}^z[i]$ (respectivement $V_{Det}^N[i]$), la variable $DETEC_z[i]$ (respectivement $DETEC_N[i]$) est initialisée à la valeur « FAUX ».

Dans une étape 3015 suivant l'étape 3014, une variable $Tempo[i]$ prend la valeur de temporisation $V_{Tempo}[i]$ correspondant à la valeur de temporisation pour le signal d'indice $i$. Dans le cas du signal fourni par l'accéléromètre, la variable $Tempo[i]$ possède quatre composantes $(Tempo_x[i], Tempo_y[i], Tempo_z[i], Tempo_N[i])$ correspondant au quatre axes $x$, $y$, $z$ et à la norme. De même, la valeur de temporisation $V_{Tempo}[i]$, possède quatre composantes ( $V_{Tempo}^x[i]$, $V_{Tempo}^y[i]$, $V_{Tempo}^z[i]$, $V_{Tempo}^N[i]$ ), toutes égales à la valeur « 300s » dans l'exemple du tableau 1. Par ailleurs, comme précédemment, seule la composante selon l'axe $z$ et la norme sont à prendre en compte dans la recherche d'une singularité. La composante $Tempo_z[i]$ (respectivement $Tempo_N[i]$) prend donc la valeur « 300s » si la composante $S_z[i]$ (respectivement la norme de $S[i]$) est supérieure ou égale à la valeur de détection $V_{Det}^z[i]$ (respectivement $V_{Det}^N[i]$ ).

Dans une étape 3017 suivant l'étape 3016, la variable *Tempo[i]* prend une valeur quelconque, par exemple la valeur « 0 ». Dans le cas du signal fourni par l'accéléromètre, la composante $Tempo_Z[i]$ (respectivement $Tempo_N[i]$) prend la valeur « 0 ».

Dans une étape 3018, la variable *i* est incrémentée d'une unité pour passer à un autre signal, par exemple pour passer au signal fourni par le capteur de fumée, le capteur de température ou le capteur de gaz inflammables. On note que les signaux fournis par le capteur de fumée, le capteur de température ou le capteur de gaz inflammables ne comportent qu'une composante et que donc leur traitement dans les étapes 3013, 3014, 3015, 3016 et 3017 est simplifié.

Dans une étape 3019, le module de traitement 171 vérifie si la variable i n'a pas atteint un nombre *N* représentant un nombre maximum de signaux à considérer. Si la variable *i* est inférieure au nombre *N,* l'étape 3019 est suivie de l'étape 3013. Sinon, la recherche d'une singularité pend fin lors d'une étape 3020. La recherche d'une singularité reprend lorsque de nouvelles valeurs courantes de signaux *S[i]* sont reçues par le module de traitement 171.

Dans un mode de réalisation, lorsque le système capteur comprend un détecteur de présence d'être vivant, préalablement à la mise en œuvre de l'étape 3012, le module de traitement 171 met en œuvre une étape 3009. Lors de l'étape 3009, le module de traitement 171 détermine, à partir d'un signal fourni par le détecteur de présence d'être vivant, si un ou plusieurs êtres vivants sont présents dans le bâtiment 1. Si aucun être vivant n'est détecté, le module de traitement 171 conserve en mémoire, lors d'une étape 3011, une information indiquant qu'une ouverture de l'organe de coupure 172 est autorisée. Si au moins un être vivant est détecté, le module de traitement 171 conserve en mémoire, lors d'une étape 3010, une information indiquant qu'une ouverture de l'organe de coupure 172 est interdite. Les étapes 3010 et 3011 sont suivies de l'étape 3012.

La Fig. **4B** illustre schématiquement un exemple d'une procédure permettant de lancer une mesure d'une durée d'une singularité.

Dans une étape 3030, le module de traitement 171 initialise une variable i à la valeur « 0 ». Cette variable *i* permet de parcourir les signaux produits par le système capteur.

Dans une étape 3031, la variable *DETEC[i]* correspondant au signal d'indice *i* est testée. Si la variable *DETEC[i]* est égale à la valeur «VRAI », le module de traitement 171 lance, dans une étape 3032, une mesure d'une durée *D[i]* de la singularité détectée correspondant au signal d'indice *i.* La durée *D[i]* va être incrémentée tant que la singularité détectée se prolonge.

On note que si la variable *DETEC[i]* comprend plusieurs composantes, comme dans le cas du signal fourni par l'accéléromètre, chaque composante de la variable *DETEC[i]* est testée, et une mesure d'une durée d'une singularité est lancée pour chaque composante égale à la valeur « VRAI ».

Dans une étape 3033, la variable *i* est incrémentée d'une unité.

Lorsque, lors de l'étape 3031, la variable *DETEC[i]* est égale à la valeur « FAUX », le module de traitement 171 met directement en œuvre l'étape 3033.

Dans une étape 3034, le module de traitement 171 vérifie si la variable *i* n'a pas atteint le nombre *N.* Si la variable *i* est inférieure au nombre *N,* l'étape 3034 est suivie de l'étape 3031. Sinon, la procédure permettant de lancer une mesure d'une durée pour chaque singularité détectée prend fin lors d'une étape 3035.

La **Fig. 4C** illustre schématiquement un exemple de procédure permettant de comparer une durée d'une singularité en cours de mesure à une valeur de temporisation.

Cette procédure est mise en œuvre régulièrement par le module de traitement 171 dès qu'au moins une mesure d'une singularité est lancée. Dès qu'une durée d'une singularité atteint une valeur de temporisation correspondant au signal dans lequel la singularité a été détectée, la procédure prend fin et une valeur représentative du signal dans lequel la singularité a été détectée est stockée en mémoire par le module de traitement 171.

Dans une étape 3040, le module de traitement 171 initialise une variable *i* à la valeur « 0 ». Cette variable *i* permet de parcourir les signaux produits par le système capteur.

Dans une étape 3041, la variable *DETEC[i]* correspondant au signal d'indice *i* est testée. Si la variable *DETEC[i]* est égale à la valeur «VRAI », le module de traitement 171 met en œuvre une étape 3042. Lors de l'étape 3042, le module de traitement obtient une valeur d'une variable *D[i]* représentant une valeur courante d'une durée d'une singularité détectée dans le signal d'indice *i*.

Dans une étape 3043, le module de traitement 171 compare la valeur de la variable *D[i]* à la valeur de la variable *Tempo[i]* correspondant au signal d'indice *i.* Si la variable *D[i]* est inférieure à la valeur de la variable *Tempo[i],* le module de traitement met en œuvre une étape 3044 au cours de laquelle la variable *i* est incrémentée d'une unité.

Dans une étape 3045, le module de traitement 171 vérifie si la variable *i* n'a pas atteint le nombre *N.* Si la variable *i* est inférieure au nombre *N,* l'étape 3045 est suivie de l'étape 3041. Sinon, la procédure permettant de comparer une durée d'une singularité en cours de mesure à une valeur de temporisation est relancée lors de l'étape 3040.

Si lors de l'étape 3043, la variable *D[i]* est supérieure ou égale à la valeur de la variable *Tempo[i],* le module de traitement met en œuvre une étape 3046. Au cours de l'étape 3046, le module de traitement mémorise la valeur de la variable *i,* la valeur de la variable i étant représentative du signal dans lequel a été détectée la singularité dont la durée est supérieure ou égale à la valeur de temporisation correspondant audit signal.

Lors d'une étape 3047, le module de traitement 171 lance une procédure de transmission régulière de messages DLMS/COSEM au système d'information centralisé 5, chaque message, dit message d'alarme, comprenant une information représentative d'une alarme et la valeur de la variable *i*. La procédure de transmission régulière de messages d'alarme reste active tant qu'au moins une singularité est détectée dans les signaux fournis par le système capteur. Des messages d'alarme sont transmis par exemple toutes les 10 minutes.

L'étape 3047 est suivie de l'étape 305 déjà expliquée.

Si, lors de l'étape 3041, la variable *DETEC*[*i*] est égale à la valeur « FAUX », le module de traitement 171 passe directement à l'étape 3044.

La **Fig. 4D** illustre schématiquement un exemple d'une procédure de détermination d'un instant d'actionnement de l'organe de coupure 172 compris dans le compteur électrique 17.

Dans un mode de réalisation, le module de traitement 171 décide d'actionner l'organe de coupure 172 dès qu'une durée d'une singularité détectée dans un signal atteint la valeur de temporisation correspondant audit signal. Le module de traitement 171 actionne donc l'organe de coupure 172 dans la position ouverte lors d'une étape 3052.

Dans un mode de réalisation dans lequel le système capteur comprend un détecteur de présence d'être vivant, le module de traitement 171 vérifie si l'ouverture de l'organe de coupure 172 est autorisée ou interdite. Pour ce faire, il consulte l'information stockée en mémoire lors des étapes 3010 ou 3011. Si l'ouverture est possible, le module de traitement 171 met en œuvre l'étape 3052. Sinon, le module de traitement se met en attente tant que le détecteur de présence d'être vivant indique qu'au moins un être vivant est présent dans le bâtiment 1. Ce n'est que quand le détecteur de présence d'être vivant indique qu'aucun être vivant n'est présent dans le bâtiment 1 que le module de traitement actionne l'organe de coupure dans la position ouverte.

Dans un mode de réalisation, chaque critère d'actionnement de l'organe de coupure 172 comprend un délai d'actionnement et une information représentative d'un instant de démarrage du délai d'actionnement. L'instant d'actionnement indique quand doit démarrer le décompte du délai d'actionnement. Comme les autres informations associées à un critère d'actionnement, le délai d'actionnement et l'information représentative d'un instant de démarrage du délai d'actionnement, peuvent être stockés par le module de traitement 171 dans un tableau, tel que le tableau 1. Lorsque le module de traitement 171 du compteur électrique 17 décide d'actionner l'organe de coupure 172 dans la position ouverte, l'organe de coupure 172 est actionné dans la position ouverte à un instant dépendant du délai d'actionnement et de l'information représentative de l'instant de démarrage du délai d'actionnement correspondant au signal dans lequel a été détectée la singularité. Dans ce mode de réalisation, préalablement à l'étape 3052, le module de traitement récupère en mémoire, lors d'une étape 3050, la valeur de la variable *i* stockée lors de l'étape 3046. Suite à la récupération de la valeur de la variable *i*, le module de traitement 171 obtient une information représentative d'un instant d'actionnement $T_{Act}[i]$ correspondant au signal d'indice *i*.

Dans un mode de réalisation, l'instant d'actionnement peut prendre trois valeurs différentes. Une première valeur de l'instant d'actionnement *T1* indique que le décompte du délai d'actionnement doit démarrer dès que la durée d'une singularité détectée dans un signal atteint la valeur de temporisation correspondant audit signal. Une seconde valeur de l'instant d'actionnement *T2* indique que le décompte du délai d'actionnement doit démarrer à partir du début de la détection d'une singularité dans un signal. Une troisième valeur de l'instant d'actionnement *T3* indique que le décompte du délai d'actionnement doit démarrer à partir de la fin de la détection d'une singularité dans un signal. Dans une étape 3051, le module de traitement 171 obtient une valeur de délai d'actionnement *DEL[i]*. Le module de traitement prend alors en compte l'information représentative d'un instant d'actionnement $T_{Act}[i]$ et la valeur de délai d'actionnement *DEL[i]* pour déterminer quand actionner l'organe de coupure 172.

Tableau 2

| N° de ligne | Type de critère | Actif | Valeur de détection | Valeur de temporisation | Action | Instant d'actionnement | Délai d'actionnement |
|---|---|---|---|---|---|---|---|
| 1 | Accélération selon un axe x | Non | 0 | 300s | Ouverture | T3 | 400s |
| 2 | Accélération selon un axe y | Non | 0 | 300s | Ouverture | T3 | 400s |
| 3 | Accélération selon un axe z | Oui | 17 mm/s$^2$ | 300s | Ouverture | T3 | 400s |
| 4 | Norme de l'accélération | Oui | 17 mm/s$^2$ | 300s | Ouverture | T3 | 400s |
| 5 | Fumée | Oui | 5 | 500s | Ouverture | T2 | 500s |
| 6 | Température | Oui | 27.4°c | 500s | Ouverture | T2 | 500s |
| 7 | Gaz | Oui | 1 | 60s | Ouverture | T1 | 0 |

Le tableau 2 est un exemple de tableau comprenant pour chaque critère, une information représentative d'un instant d'actionnement et une valeur de délai d'actionnement. Comme on peut le voir dans le tableau 2, chaque critère adapté au signal fourni par l'accéléromètre indique une information représentative d'un instant d'actionnement *T3* et un délai d'actionnement de « 400s ». Par conséquent, si une singularité d'une durée de « 300s » est détectée dans le signal fourni par l'accéléromètre, l'organe de coupure 172 est actionné dans la position ouverte après un délai de « 400s » à compter de la fin de la singularité. Si la singularité est provoquée par un tremblement de terre, l'organe de coupure 172 est actionné dans la position ouverte après un délai de « 400s » à compter de la fin du tremblement de terre.

Les critères adaptés au signal fourni par le capteur de fumée et au capteur de température indiquent une information représentative d'un instant d'actionnement *T2* et un délai d'actionnement de « 500s ». Par conséquent, si une singularité d'une durée de « 500s » est détectée dans le signal fourni par le capteur de fumée ou le capteur de température, l'organe de coupure 172 est actionné dans la position ouverte après un délai de « 500s » à compter du début de la singularité.

Le critère adapté au signal fourni par le capteur de gaz inflammables indique une information représentative d'un instant d'actionnement *T1* et un délai d'actionnement égal à la valeur « 0 ». Par conséquent, si une singularité d'une durée de « 60s » est détectée dans le signal fourni par le capteur de gaz inflammables, l'organe de coupure 172 est actionné dans la position ouverte dès que la durée de la singularité atteint « 60s ».

Suite à l'actionnement de l'organe de coupure 172 dans la position ouverte après détection dans un signal d'une singularité d'une durée au moins égale à la valeur de temporisation correspondant audit signal, le module de traitement 171 du compteur électrique 17 actionne l'organe de coupure 172 dans la position fermée après réception d'une commande de la part du système d'information centralisé 5. Le système d'information centralisé 5 transmet cette information lorsqu'il cesse de recevoir des messages d'alarme de la part du compteur électrique 17. Par ailleurs, on sait qu'un évènement dangereux tel qu'un tremblement de terre et un incendie peut endommager des réseaux de communications, et notamment le réseau de communication reliant le compteur électrique 17 au système d'information centralisé 5. La commande d'actionner l'organe de coupure 172 dans la position fermée ne peut alors être transmise que lorsque le réseau de communication est rétabli.

Dans un mode de réalisation, le système d'information centralisé 5 n'envoie la commande d'actionner l'organe de coupure dans la position fermée que lorsqu'il ne reçoit plus de messages d'alarme du compteur électrique 17 ou de compteurs électriques situés dans un voisinage du compteur électrique 17.

**Revendications**

1. Procédé d'actionnement d'un organe de coupure (172) compris dans un compteur électrique (17) supervisant une installation électrique (14) d'un bâtiment (1), l'installation électrique (14) recevant une alimentation électrique d'un réseau électrique (2) via ledit compteur électrique (17), l'organe de coupure (172) pouvant prendre une position ouverte coupant l'alimentation électrique de ladite installation électrique (14) ou une position fermée permettant l'alimentation électrique de ladite installation électrique (14), **caractérisé en ce que** le procédé comprend les étapes suivantes mises en œuvre par le compteur électrique (17) :

   obtenir (300) pour chaque signal fourni par un système, dit système capteur, un critère d'actionnement de l'organe de coupure (172) adapté audit signal, chaque critère d'actionnement comprenant une valeur de détection et une valeur de temporisation et chaque signal étant représentatif de conditions environnementales du bâtiment (1) régnant dans un voisinage dudit système capteur ;

   pour chaque signal fourni par le système capteur, rechercher (301) une singularité dans ledit signal, une singularité étant détectée dans ledit signal lorsqu'au moins une valeur dudit signal atteint la valeur de détection correspondant audit signal ;

   lorsqu'une singularité est détectée (302) dans un dit signal fourni par le système capteur,

   démarrer (303) une mesure d'une durée de ladite singularité ;

   décider (305), lorsque la durée de ladite singularité atteint (304) la valeur de temporisation correspondant audit signal, d'un instant auquel l'organe de coupure (172) doit être actionné dans la position ouverte ; et,

   actionner (3052) l'organe de coupure (172) dans la position ouverte à l'instant décidé.

2. Procédé selon la revendication 1, **caractérisé en ce que** le compteur électrique (17) comprend un moyen d'alimentation électrique interne (173), le moyen d'alimentation électrique interne (173) alimentant le compteur électrique (17) lorsque l'alimentation électrique par le réseau électrique (2) est coupée, pour permettre l'actionnement de l'organe de coupure (172).

3. Procédé selon la revendication 1 ou 2, **caractérisé en ce que** chaque critère d'actionnement comprend un délai d'actionnement et une information représentative d'un instant de démarrage du délai d'actionnement, et lorsque le compteur électrique (17) décide d'actionner l'organe de coupure (172) dans la position ouverte, l'organe de coupure (172) est actionné dans la position ouverte à un instant dépendant du délai d'actionnement et de l'information représentative de l'instant de démarrage du délai d'actionnement correspondant au signal dans lequel a été détectée la singularité.

4. Procédé selon la revendication 3, **caractérisé en ce que** le système capteur comprend au moins un capteur apte à fournir un signal représentatif de mouvements sismiques, dit capteur sismique, et/ou au moins un capteur de température et/ou au moins un capteur de fumée et/ou un capteur de gaz inflammables.

5. Procédé selon la revendication 4, **caractérisé en ce que**, lorsqu'un signal dans lequel a été détectée une singularité est fourni par un dit capteur sismique, l'organe de coupure (172) est actionné dans la position ouverte après un délai égal au délai d'actionnement adapté au signal fourni par le capteur sismique à compter de la fin de la singularité.

6. Procédé selon la revendication 4, **caractérisé en ce que** lorsqu'un signal dans lequel a été détectée une singularité est fourni par un dit capteur de température ou par un dit capteur de fumée, l'organe de coupure (172) est actionné dans la position ouverte après un délai égal au délai d'actionnement adapté au signal fourni respectivement par le capteur de température ou par le capteur de fumée à compter du début de la détection de la singularité.

7. Procédé selon la revendication 4, **caractérisé en ce que** lorsqu'un signal dans lequel a été détectée une singularité est fourni par un dit capteur de gaz inflammables, le délai d'actionnement est nul et l'organe de coupure (172) est actionné dès que la durée de la singularité atteint la valeur de temporisation.

8. Procédé selon l'une quelconque des revendications 4 à 7, **caractérisé en ce que** le système capteur comprend en outre un détecteur fournissant un signal représentatif de présence ou d'absence d'êtres vivants dans le bâtiment (1), et **en ce que** l'instant auquel l'organe de coupure (172) doit être actionné est déterminé en prenant en compte ledit signal représentatif de présence ou d'absence d'êtres vivants.

9. Procédé selon l'une quelconque des revendications précédentes dans lequel le compteur électrique (17) reçoit chaque critère d'actionnement de l'organe de coupure (172) en provenance d'un système d'information (5) connecté au compteur électrique (17) par un réseau de communication établi par courants porteurs en ligne sur ledit réseau électrique (2).

10. Procédé selon la revendication 9, **caractérisé en ce que** le compteur électrique (17) transmet, via ledit réseau de communication, un signal d'alarme en direction du système d'information (5) dès que la durée de la singularité détectée atteint la valeur de temporisation et tant que la singularité ne cesse pas.

11. Procédé selon la revendication 10, **caractérisé en ce que** suite à l'actionnement de l'organe de coupure (172) dans la position ouverte après détection dans un signal d'une singularité d'une durée au moins égale à la valeur de temporisation correspondant audit signal, le compteur électrique (17) actionne l'organe de coupure (172) dans la position fermée après réception d'une commande de la part du système d'information (5) via ledit réseau de communication.

12. Dispositif de type compteur électrique (17) supervisant une installation électrique (14) d'un bâtiment (1), l'installation électrique (14) recevant une alimentation électrique d'un réseau électrique (2) via ledit compteur électrique (17), et comprenant un organe de coupure (172) pouvant prendre une position ouverte coupant l'alimentation électrique de ladite installation électrique (14) ou une position fermée permettant l'alimentation électrique de ladite installation électrique (14), **caractérisé en ce que** le dispositif comprend les moyens suivants :

des moyens (300) d'obtention pour obtenir, pour chaque signal fourni au dispositif par un système, dit système capteur, un critère d'actionnement de l'organe de coupure (172) adapté audit signal, chaque critère d'actionnement comprenant une valeur de détection et une valeur de temporisation et chaque signal étant représentatif de conditions environnementales du bâtiment (1) régnant dans un voisinage dudit système capteur ;
des moyens (301) de recherche mis en œuvre sur chaque signal fourni par le système capteur, pour rechercher une singularité dans chaque signal, une singularité étant détectée dans un dit signal lorsqu'au moins une valeur dudit signal atteint la valeur de détection correspondant audit signal ;
des moyens (303) de mesure pour mesurer une durée d'une singularité lorsqu'une singularité est détectée dans un dit signal fourni par le système capteur ;

des moyens (305) de décision pour décider, lorsque la durée de ladite singularité atteint (304) la valeur de temporisation correspondant audit signal, d'un instant auquel l'organe de coupure (172) doit être actionné dans la position ouverte ;

des moyens d'actionnement pour actionner l'organe de coupure (172) dans la position ouverte à l'instant décidé ;

des moyens (173) d'alimentation électrique interne, aptes à alimenter le compteur électrique (17) lorsque l'alimentation électrique par le réseau électrique (2) est coupée, pour permettre l'actionnement de l'organe de coupure (172).

**13.** Dispositif de type système d'information (5) connecté à au moins un compteur électrique (17) par l'intermédiaire d'un réseau de communication, chaque compteur électrique supervisant une installation électrique (14) d'un bâtiment (1) et recevant une alimentation électrique d'un réseau électrique (2), chaque compteur électrique (17) comprenant un organe de coupure (172) pouvant prendre une position ouverte coupant l'alimentation électrique de ladite installation électrique (14) ou une position fermée permettant l'alimentation électrique de ladite installation électrique (14), **caractérisé en ce que** le dispositif (5) comprend les moyens suivants :

des moyens d'obtention pour obtenir, pour chaque compteur électrique (17), un critère d'actionnement de l'organe de coupure (172) pour chaque signal fourni par un système, dit système capteur, fournissant au compteur électrique (17) au moins un signal représentatif de conditions environnementales du bâtiment (1) régnant dans un voisinage dudit système capteur, chaque critère d'actionnement étant adapté au signal auquel il correspond et chaque critère d'actionnement comprenant une valeur de détection et une valeur de temporisation ;

des moyens de fourniture pour fournir à chaque compteur électrique, via ledit réseau de communication, chaque critère d'actionnement déterminé pour ledit compteur électrique ;

des moyens de réception pour recevoir, via le réseau de communication, un signal d'alarme transmis par un compteur électrique (17), suite à une détection dans un signal fourni par le système capteur dudit compteur électrique (17) d'une singularité d'une durée au moins égale à la valeur de la temporisation correspondant audit signal, une singularité étant détectée dans ledit signal lorsqu'au moins une valeur dudit signal atteint la valeur de détection correspondant audit signal ;

des moyens de commande pour autoriser un compteur électrique (17), ayant actionné en position ouverte son organe de coupure (172) suite à une détection d'une singularité dans un dit signal fourni par le système capteur d'une durée égale à la valeur de temporisation correspondant audit signal, à actionner en position fermée son organe de coupure (172) lorsque le dispositif (5) ne reçoit plus de signal d'alarme de la part dudit compteur électrique (17).

**14.** Programme d'ordinateur, **caractérisé en ce qu'**il comprend des instructions pour mettre en œuvre, par un compteur électrique (17), le procédé selon l'une quelconque des revendications 1 à 11, lorsque ledit programme est exécuté par un processeur (1711) dudit compteur électrique.

**15.** Moyens de stockage, **caractérisés en ce qu'**ils stockent un programme d'ordinateur comprenant des instructions pour mettre en œuvre, par un compteur électrique (17), le procédé selon l'une quelconque des revendications 1 à 11, lorsque ledit programme est exécuté par un processeur (1711) dudit compteur électrique (17).

**Patentansprüche**

**1.** Verfahren zur Betätigung eines Abschaltelements (172), das in einem elektrischen Zähler (17) enthalten ist, der eine elektrische Anlage (14) eines Gebäudes (1) überwacht, wobei die elektrische Anlage (14) von einem Stromnetz (2) über den elektrischen Zähler (17) mit Strom versorgt wird, wobei das Abschaltelement (172) eine geöffnete Position, welche die Stromversorgung der elektrischen Anlage (14) unterbricht, oder eine geschlossene Position, welche die Stromversorgung der elektrischen Anlage (14) ermöglicht, einnehmen kann, **dadurch gekennzeichnet, dass** das Verfahren die folgenden Schritte umfasst, die von dem elektrischen Zähler (17) durchgeführt werden:

Gewinnen (300), für jedes von einem System, Sensorsystem genannt, gelieferte Signal, eines Kriteriums der Betätigung des Abschaltelements (172), das an das Signal angepasst ist, wobei jedes Kriterium einen Detektionswert und einen Verzögerungszeitwert umfasst, wobei jedes Signal für Umgebungsbedingungen des Gebäudes (1) repräsentativ ist, die in einer Umgebung des Sensorsystems vorherrschen;

für jedes von dem Sensorsystem gelieferte Signal, Suchen (301) nach einer Singularität in dem Signal, wobei eine Singularität in dem Signal erkannt wird, wenn wenigstens ein Wert des Signals den Detektionswert erreicht, der dem Signal entspricht;

wenn eine Singularität in einem solchen von dem Sensorsystem gelieferten Signal erkannt wird (302), Starten (303) einer Messung einer Dauer der Singularität;

Festlegen (305), wenn die Dauer der Singularität den Verzögerungszeitwert erreicht (304), der dem Signal entspricht, eines Zeitpunkts, zu dem das Abschaltelement (172) in die geöffnete Position betätigt werden soll; und Betätigen (3052) des Abschaltelements (172) in die geöffnete Position zu dem festgelegten Zeitpunkt.

2.  Verfahren nach Anspruch 1, **dadurch gekennzeichnet, dass** der elektrische Zähler (17) ein Mittel zur internen Stromversorgung (173) umfasst, wobei das Mittel zur internen Stromversorgung (173) den elektrischen Zähler (17) versorgt, wenn die Stromversorgung durch das Stromnetz (2) unterbrochen ist, um die Betätigung des Abschaltelements (172) zu ermöglichen.

3.  Verfahren nach Anspruch 1 oder 2, **dadurch gekennzeichnet, dass** jedes Betätigungskriterium eine Betätigungsverzögerung und eine Information, die für einen Startzeitpunkt der Betätigungsverzögerung repräsentativ ist, umfasst, und wenn der elektrische Zähler (17) entscheidet, das Abschaltelement (172) in die geöffnete Position zu betätigen, das Abschaltelement (172) zu einem Zeitpunkt in die geöffnete Position betätigt wird, der von der Betätigungsverzögerung und der Information, die für den Startzeitpunkt der Betätigungsverzögerung repräsentativ ist, abhängig ist, die dem Signal entsprechen, in welchem die Singularität erkannt worden ist.

4.  Verfahren nach Anspruch 3, **dadurch gekennzeichnet, dass** das Sensorsystem wenigstens einen Sensor, der in der Lage ist, ein Signal zu liefern, das für seismische Bewegungen repräsentativ ist, seismischer Sensor genannt, und/oder wenigstens einen Temperatursensor und/oder wenigstens einen Rauchsensor und/oder einen Sensor für brennbare Gase umfasst.

5.  Verfahren nach Anspruch 4, **dadurch gekennzeichnet, dass**, wenn ein Signal, in welchem eine Singularität erkannt worden ist, von einem besagten seismischen Sensor geliefert wird, das Abschaltelement (172) nach einer Verzögerung ab dem Ende der Singularität, die gleich der an das von dem seismischen Sensor gelieferte Signal angepassten Betätigungsverzögerung ist, in die geöffnete Position betätigt wird.

6.  Verfahren nach Anspruch 4, **dadurch gekennzeichnet, dass**, wenn ein Signal, in welchem eine Singularität erkannt worden ist, von einem besagten Temperatursensor oder von einem besagten Rauchsensor geliefert wird, das Abschaltelement (172) nach einer Verzögerung ab dem Beginn der Erkennung der Singularität, die gleich der an das von dem Temperatursensor bzw. von dem Rauchsensor gelieferte Signal angepassten Betätigungsverzögerung ist, in die geöffnete Position betätigt wird.

7.  Verfahren nach Anspruch 4, **dadurch gekennzeichnet, dass**, wenn ein Signal, in welchem eine Singularität erkannt worden ist, von einem besagten Sensor für brennbare Gase geliefert wird, die Betätigungsverzögerung null ist und das Abschaltelement (172) betätigt wird, sobald die Dauer der Singularität den Verzögerungszeitwert erreicht.

8.  Verfahren nach einem der Ansprüche 4 bis 7, **dadurch gekennzeichnet, dass** das Sensorsystem außerdem einen Detektor umfasst, der ein Signal liefert, das für die Anwesenheit oder Nichtanwesenheit von Lebewesen in dem Gebäude (1) repräsentativ ist, und dadurch, dass der Zeitpunkt, zu welchem das Abschaltelement (172) betätigt werden muss, unter Berücksichtigung des Signals, das für die Anwesenheit oder Nichtanwesenheit von Lebewesen repräsentativ ist, bestimmt wird.

9.  Verfahren nach einem der vorhergehenden Ansprüche, wobei der elektrische Zähler (17) jedes Kriterium der Betätigung des Abschaltelements (172) von einem Informationssystem (5) empfängt, das mit dem elektrischen Zähler (17) über ein Kommunikationsnetz verbunden ist, das durch Powerline Communication auf dem Stromnetz (2) hergestellt ist.

10. Verfahren nach Anspruch 9, **dadurch gekennzeichnet, dass** der elektrische Zähler (17) über das Kommunikationsnetz ein Alarmsignal an das Informationssystem (5) überträgt, sobald die Dauer der erkannten Singularität den Verzögerungszeitwert erreicht, und solange die Singularität nicht beendet ist.

11. Verfahren nach Anspruch 10, **dadurch gekennzeichnet, dass** im Anschluss an die Betätigung des Abschaltelements (172) in die geöffnete Position nach Erkennung, in einem Signal, einer Singularität mit einer Dauer, die mindestens gleich dem diesem Signal entsprechenden Verzögerungszeitwert ist, der elektrische Zähler (17) das Abschaltelement (172) nach Empfang eines Befehls von dem Informationssystem (5) über das Kommunikationsnetz in die geschlossene Position betätigt.

**12.** Vorrichtung vom Typ eines elektrischen Zählers (17), der eine elektrische Anlage (14) eines Gebäudes (1) überwacht, wobei die elektrische Anlage (14) von einem Stromnetz (2) über den elektrischen Zähler (17) mit Strom versorgt wird, und der ein Abschaltelement (172) umfasst, das eine geöffnete Position, welche die Stromversorgung der elektrischen Anlage (14) unterbricht, oder eine geschlossene Position, welche die Stromversorgung der elektrischen Anlage (14) ermöglicht, einnehmen kann, **dadurch gekennzeichnet, dass** die Vorrichtung die folgenden Mittel umfasst:

Gewinnungsmittel (300) zum Gewinnen, für jedes von einem System, Sensorsystem genannt, an die Vorrichtung gelieferte Signal, eines Kriteriums der Betätigung des Abschaltelements (172), das an das Signal angepasst ist, wobei jedes Kriterium einen Detektionswert und einen Verzögerungszeitwert umfasst, wobei jedes Signal für Umgebungsbedingungen des Gebäudes (1) repräsentativ ist, die in einer Umgebung des Sensorsystems vorherrschen;

Suchmittel (301), die für jedes von dem Sensorsystem gelieferte Signal eingesetzt werden, um nach einer Singularität in jedem Signal zu suchen, wobei eine Singularität in einem solchen Signal erkannt wird, wenn wenigstens ein Wert des Signals den Detektionswert erreicht, der dem Signal entspricht;

Messmittel (303) zum Messen einer Dauer einer Singularität, wenn eine Singularität in einem solchen von dem Sensorsystem gelieferten Signal erkannt wird;

Entscheidungsmittel (305) zum Festlegen, wenn die Dauer der Singularität den Verzögerungszeitwert erreicht (304), der dem Signal entspricht, eines Zeitpunkts, zu dem das Abschaltelement (172) in die geöffnete Position betätigt werden soll;

Betätigungsmittel zum Betätigen des Abschaltelements (172) in die geöffnete Position zu dem festgelegten Zeitpunkt;

Mittel (173) zur internen Stromversorgung, die in der Lage sind, den elektrischen Zähler (17) zu versorgen, wenn die Stromversorgung durch das Stromnetz (2) unterbrochen ist, um die Betätigung des Abschaltelements (172) zu ermöglichen.

**13.** Vorrichtung vom Typ eines Informationssystems (5), das mit mindestens einem elektrischen Zähler (17) über ein Kommunikationsnetz verbunden ist, wobei jeder elektrische Zähler eine elektrische Anlage (14) eines Gebäudes (1) überwacht und von einem Stromnetz (2) mit Strom versorgt wird, wobei jeder elektrische Zähler (17) ein Abschaltelement (172) umfasst, das eine geöffnete Position, welche die Stromversorgung der elektrischen Anlage (14) unterbricht, oder eine geschlossene Position, welche die Stromversorgung der elektrischen Anlage (14) ermöglicht, einnehmen kann, **dadurch gekennzeichnet, dass** die Vorrichtung (5) die folgenden Mittel umfasst:

Gewinnungsmittel zum Gewinnen, für jeden elektrischen Zähler (17), eines Kriteriums der Betätigung des Abschaltelements (172) für jedes Signal, das von einem System, Sensorsystem genannt, geliefert wird, das an den elektrischen Zähler (17) wenigstens ein Signal liefert, das für Umgebungsbedingungen des Gebäudes (1) repräsentativ ist, die in einer Umgebung des Sensorsystems vorherrschen, wobei jedes Betätigungskriterium an das Signal angepasst ist, dem es entspricht, und jedes Kriterium einen Detektionswert und einen Verzögerungszeitwert umfasst;

Liefermittel zum Liefern, an jeden elektrischen Zähler über das Kommunikationsnetz, jedes Abschaltkriteriums, das für den elektrischen Zähler bestimmt wird;

Empfangsmittel zum Empfangen, über das Kommunikationsnetz, eines Alarmsignals, das von einem elektrischen Zähler (17) im Anschluss an eine Erkennung, in einem von dem Sensorsystem des elektrischen Zählers (17) gelieferten Signal, einer Singularität von einer Dauer, die mindestens gleich dem diesem Signal entsprechenden Verzögerungszeitwert ist, übertragen wird, wobei eine Singularität in dem Signal erkannt wird, wenn wenigstens ein Wert des Signals den Detektionswert erreicht, der dem Signal entspricht;

Steuerungsmittel, um einem elektrischen Zähler (17), der sein Abschaltelement (172) im Anschluss an eine Erkennung einer Singularität in einem von dem Sensorsystem gelieferten besagten Signal von einer Dauer, die gleich dem diesem Signal entsprechenden Verzögerungszeitwert ist, in die geöffnete Position betätigt hat, zu gestatten, sein Abschaltelement (172) in die geschlossene Position zu betätigen, wenn die Vorrichtung (5) von dem elektrischen Zähler (17) kein Alarmsignal mehr empfängt.

**14.** Computerprogramm, **dadurch gekennzeichnet, dass** es Anweisungen zur Durchführung, durch einen elektrischen Zähler (17), des Verfahrens nach einem der Ansprüche 1 bis 11, wenn das Programm von einem Prozessor (1711) des elektrischen Zählers ausgeführt wird, umfasst.

**15.** Speichermittel, **dadurch gekennzeichnet, dass** sie ein Computerprogramm speichern, das Anweisungen zur Durchführung, durch einen elektrischen Zähler (17), des Verfahrens nach einem der Ansprüche 1 bis 11, wenn das Programm von einem Prozessor (1711) des elektrischen Zählers (17) ausgeführt wird, umfasst.

**Claims**

1. Method for actuating a cut-off member (172) included in an electric meter (17) supervising an electrical installation (14) of a building (1), the electrical installation (14) receiving an electrical power supply from an electrical network (2) via said electric meter (17), the cut-off member (172) being able to take an open position cutting the electrical power supply of said electrical installation (14) or a closed position allowing the electrical power supply of said electrical installation (14), **characterized in that** the method comprises the following steps implemented by the electric meter (17) :

   obtaining (300), for each signal supplied by a system, called sensor system, a criterion of actuation of the cut-off member (172) suited to said signal and each criterion comprises a detection value and a timer value, each signal being representative of environmental conditions of the building (1) prevailing in a vicinity of said sensor system;
   for each signal supplied by the sensor system, searching (301) for a singularity in said signal, a singularity being detected in said signal when at least one value of said signal reaches the detection value corresponding to said signal;
   when a singularity is detected (302) in one said signal supplied by the sensor system,
   starting (303) a measurement of a duration of said singularity;
   deciding (305), when the duration of said singularity reaches (304) the timer value corresponding to said signal, of an instant at which the cut-off member (172) must be actuated into the open position; and,
   actuating (3052) the cut-off member (172) into the open position at the decided instant.

2. Method according to Claim 1, **characterized in that** the electric meter (17) comprises an internal electrical power supply means (173), the internal electrical power supply means (173) supplying the electric meter (17) when the electrical power supply by the electrical network (2) is cut, to allow the actuation of the cut-off member (172).

3. Method according to Claim 1 or 2, **characterized in that** each actuation criterion comprises an actuation delay and information representative of an instant of starting of the actuation delay, and, when the electric heater (17) decides to actuate the cut-off member (172) into the open position, the cut-off member (172) is actuated into the open position at an instant dependent on the actuation delay and on the information representative of the instant of starting of the actuation delay corresponding to the signal in which the singularity has been detected.

4. Method according to Claim 3, **characterized in that** the sensor system comprises at least one sensor capable of supplying a signal representative of seismic movements, called seismic sensor, and/or at least one temperature sensor and/or at least one smoke sensor and/or at least one flammable gas sensor.

5. Method according to Claim 4, **characterized in that**, when a signal in which a singularity has been detected is supplied by one said seismic sensor, the cut-off member (172) is actuated into the open position after a delay equal to the actuation delay suited to the signal supplied by the seismic sensor, to be counted from the end of the singularity.

6. Method according to Claim 4, **characterized in that**, when a signal in which a singularity has been detected is supplied by one said temperature sensor or by one said smoke sensor, the cut-off member (172) is actuated into the open position after a delay equal to the actuation delay suited to the signal supplied respectively by the temperature sensor or by the smoke sensor, to be counted from the start of the detection of the singularity.

7. Method according to Claim 4, **characterized in that**, when a signal in which a singularity has been detected is supplied by one said flammable gas sensor, the actuation delay is nil and the cut-off member (172) is actuated as soon as the duration of the singularity reaches the timer value.

8. Method according to any one of Claims 4 to 7, **characterized in that** the sensor system further comprises a detector supplying a signal representative of presence or of absence of living beings in the building (1), and **in that** the instant at which the cut-off member (172) must be actuated is determined by taking account of said signal representative of presence or of absence of living beings.

9. Method according to any one of the preceding claims, wherein the electric meter (17) receives each criterion of actuation of the cut-off member (172) from an information system (5) connected to the electric heater (17) by a communication network established by power line communications on said electrical network (2).

10. Method according to Claim 9, **characterized in that** the electric meter (17) transmits, via said communication network, an alarm signal towards the information system (5) as soon as the duration of the detected singularity reaches the timer value and as long as the singularity does not cease.

11. Method according to Claim 10, **characterized in that**, following the actuation of the cut-off member (172) into the open position after detection in a signal of a singularity of a duration at least equal to the timer value corresponding to said signal, the electric meter (17) actuates the cut-off member (172) into the closed position after reception of a command from the information system (5) via said communication network.

12. Device of electric meter (17) type supervising an electrical installation (14) of a building (1), the electrical installation (14) receiving an electrical power supply from an electrical network (2) via said electric meter (17), and comprising a cut-off member (172) that can take an open position cutting the electrical power supply of said electrical installation (14) or a closed position allowing the electrical power supply of said electrical installation (14), **characterized in that** the device comprises the following means:

> obtaining means (300) for obtaining, for each signal supplied to the device by a system, called sensor system, a criterion of actuation of the cut-off member (172) suited to said signal and each criterion comprises a detection value and a timer value, each signal being representative of environmental conditions of the building (1) prevailing in a vicinity of said sensor system;
> searching means (301) applied to each signal supplied by the sensor system, the search for a singularity in each signal, a singularity being detected in one said signal when at least one value of said signal reaches the detection value corresponding to said signal;
> measurement means (303) for measuring a duration of a singularity when a singularity is detected in one said signal supplied by the sensor system;
> decision means (305) for deciding, when the duration of said singularity reaches (304) the timer value corresponding to said signal, of an instant at which the cut-off member (172) must be actuated into the open position;
> actuation means for actuating the cut-off member (172) into the open position at the decided instant;
> internal electrical power supply means (173), capable of supplying power to the electric meter (17) when the electrical power supply by the electrical network (2) is cut, to allow the actuation of the cut-off member (172).

13. Device of information system type (5) connected to at least one electric meter (17) via a communication network, each electric meter supervising an electrical installation (14) of a building (1) and receiving an electrical power supply from an electrical network (2), each electric meter (17) comprising a cut-off member (172) that can take an open position cutting the electrical power supply of said electrical installation (14) or a closed position allowing the electrical power supply of said electrical installation (14), **characterized in that** the device (5) comprises the following means:

> obtaining means for obtaining, for each electric meter (17), a criterion of actuation of the cut-off member (172) for each signal supplied by a system, called sensor system, supplying to the electric meter (17) at least one signal representative of environmental conditions of the building (1) prevailing in a vicinity of said sensor system, each actuation criterion being suited to the signal to which it corresponds and each criterion comprises a detection value and a timer value;
> supply means for supplying, to each electric meter, via said communication network, each cut-off criterion determined for said electric meter;
> reception means for receiving, via the communication network, an alarm signal transmitted by an electric meter (17) following a detection, in a signal supplied by the sensor system of said electric meter (17), of a singularity of a duration at least equal to the value of the timer corresponding to said signal, a singularity being detected in said signal when at least one value of said signal reaches the detection value corresponding to said signal;
> control means for allowing an electric meter (17), having actuated its cut-off member (172) into open position following a detection of a singularity in one said signal supplied by the sensor system of a duration equal to the timer value corresponding to said signal, to actuate its cut-off member (172) into closed position when the device (5) no longer receives the alarm signal from said electric meter (17) .

14. Computer program, **characterized in that** it comprises instructions for the implemention, by an electric meter (17), of the method according to any one of Claims 1 to 11, when said program is executed by a processor (1711) of said electric meter.

**15.** Storage means, **characterized in that** they store a computer program comprising instructions for the implementation, by an electric meter (17) of the method according to any one of Claims 1 to 11, when said program is executed by a processor (1711) of said electric meter (17).

Fig. 1

| 1711 CPU | 1712 RAM | 1713 ROM |

1710

HDD 1714    COM 1715

171

## Fig. 2

Obtention critères de coupure — 300

Recherche singularités — 301

Détection singularité ? — 302

Oui

Démarrage mesure durée singularité D — 303

Non ← Durée singularité ≥ Temporisation → Oui

Pas de décision possible — 306

Décision d'actionner l'organe de coupure possible — 305

304

## Fig. 3

3010

Ouverture
interdite

Oui

3009

Présence être vivant ?

Non

3011

Ouverture
autorisée

3012

$i=0$

3016

$DETEC[i] = FAUX$

Non

3013

$S[i] \geq V_{Det}[i]?$

Oui

3014

$DETEC[i] = VRAI$

3017

$Tempo[i]=0$

3015

$Tempo[i]=V_{Tempo}[i]$

3018

$i=i+1$

3019

$i < N?$

Oui

Non

3020

Fin recherche

Fig. 4A

3030

$i=0$

Non

3031

$DETEC[i] = VRAI ?$

Oui

3032

Démarrage mesure
durée $D[i]$

3033

$i=i+1$

3034

$i < N?$

Oui

Non

3035

Fin démarrage

Fig. 4B

$i=0$ ⌐ 3040

Non ← $DETEC[i] = VRAI$ ? ⌐ 3041

Oui

Vérification valeur $D[i]$ ⌐ 3042

$D[i] \geq Tempo[i]$ ? ⌐ 3043 → Mémorisation ⌐ 3046

Oui

Message d'alarme ⌐ 3047

Non

$i=i+1$ ⌐ 3044

305

$i < N$? ⌐ 3045

Non        Oui

## Fig. 4C

Instant
d'actionnement =
$T_{Act}[i]$ ⌐ 3050

Délai
d'actionnement =
$DEL[i]$ ⌐ 3051

Actionnement ⌐ 3052

## Fig. 4D

## RÉFÉRENCES CITÉES DANS LA DESCRIPTION

**Documents brevets cités dans la description**

- EP 2080177 B1